# EUROPÄISCHE PATENTSCHRIFT

(11) **EP 0 389 916 B1**
(45) Veröffentlichungstag und Bekanntmachung des Hinweises auf die Patenterteilung: **07.09.1994**
(21) Anmeldenummer: 90105172.2
(22) Anmeldetag: 20.03.1990
(51) Int. Cl.: G01N 27/02

(54) **Messvorrichtung zur Bestimmung der dielektrischen Eigenschaften von Stoffen**
Apparatus for measuring the dielectric properties of materials
Appareil de mesure des propriétés diélectriques des matériaux

(30) Priorität: 25.03.1989 DE 3909851
(43) Veröffentlichungstag der Anmeldung: 03.10.1990
(73) Patentinhaber: Halstrup, Erwin, D-79199 Kirchzarten (DE)
(72) Erfinder: Halstrup, Erwin, D-79199 Kirchzarten (DE)
(74) Vertreter: Patent- und Rechtsanwaltssozietät, Schmitt, Maucher & Börjes

(56) Entgegenhaltungen:
- EP-A- 0 107 545
- WO-A-85/03777
- CH-A- 419 670
- DE-A- 1 798 362

## Beschreibung

Die Erfindung betrifft eine Meßvorrichtung zur Bestimmung der dielektrischen Eigenschaften eines Prüflings aus Stoffen in beliebigem Aggregatzustand, zum Beispiel von Nichtleitern, Halbleitern, Isolierstoffen, Baustoffen, Baumaterialien, Bodenproben, Schüttgütern, Lösungen, Lösungsmitteln, Gasen usw., mit einer Spule, die Bestandteil eines Schwingkreises ist, zur Erzeugung eines magnetischen Wechselfeldes, in welches der Prüfling eintaucht.

Bei der Messung von Feuchtigkeit in Werkstoffen besteht das Problem, daß ein direkter Kontakt mit dem Prüfling häufig nicht möglich oder nicht erwünscht ist. Es sind deshalb außer den konduktiven Messungen auch schon Leitfähigkeitsmessungen mit induktiver Kopplung bekannt. Die Feuchtemessung erfolgt hierbei indirekt über den Elektrolytgehalt der Flüssigkeit. Dabei ergeben sich vergleichsweise hohe Ungenauigkeiten unter anderem wegen der starken Temperaturabhängigkeit der Leitfähigkeit des Elektrolyts. Zur Untersuchung von nichtleitenden Werkstoffen ist dieses Verfahren ungeeignet.

Außerdem kennt man bereits ein kapazitives Meßprinzip zur Feuchtemessung, wobei die kapazitiven Änderungen in einem aufgebauten dielektrischen Wechselfeld erfaßt werden. Damit ist jedoch nur eine geringe Eindringtiefe und somit eine Oberflächenmessung möglich. Außerdem geht hierbei die elektrolytische Leitfähigkeit stark in die Messung ein.
Auch kennt man ein induktives Meßverfahren, bei dem eine ein magnetisches Wechselfeld erzeugende Spule sich in dem Prüfling, zum Beispiel einer Flüssigkeit, befindet oder aber wobei die Spule den Prüfling umgreift. Eine entsprechende Meßvorrichtung läßt sich zwar im Laborbereich in einigen Fällen anwenden, für eine Vielzahl von praktischen Anwendungsfällen, zum Beispiel die Feuchtemessung in Mauerwerken usw. ist sie jedoch nicht einsetzbar.

Aus der CH-A-419670 ist ein Verfahren zur Untersuchung nichtmagnetischer Stoffe bekannt, wobei der zu untersuchende Stoff die Güte einer Spule beeinflußt und die Güteänderung als Maß für die Eigenschaft des Stoffes verwendet wird. Bei einer Feuchtemessung wird mit dieser Meßvorrichtung außer dem Feuchtegehalt auch noch der Elektrolytgehalt gemessen, so daß die Messung der Feuchte durch einen unterschiedlichen Elektrolytgehalt beeinflußt wird.

Aufgabe der Erfindung ist es, eine Meßvorrichtung der eingangs erwähnten Art zu schaffen, die einen wesentlich erweiterten Anwendungsbereich ermöglicht. Dabei sollen unter anderem insbesondere Feuchtemessungen, Konzentrationsmessungen, Gasanalysen usw. durchführbar sein, wobei an dem Prüfling selbst keine oder bedarfsweise nur geringe Anpassungen erforderlich sein sollen.

Zur Lösung dieser Aufgabe wird vorgeschlagen, daß die Feldspule einen magnetisierbaren Kern aufweist und daß der Schwingkreis zur Messung der Dielektrizitätskonstanten des Prüflings ein großes L/C-Verhältnis mit kleiner Schwingkreiskapazität von etwa 0,1 Picofarad bis zu etwa 50 Picofarad aufweist.

Mit dieser Meßvorrichtung kann die Dielektrizitätskonstante von beliebigen Nichtleitern, also festen, flüssigen oder gasförmigen Stoffen gemessen werden, wobei die zu messende Probe in das magnetische Wechselfeld der mit Wechselstrom durchflossenen Feldspule gebracht und die Belastung der Spule beziehungsweise die auftretende Rückwirkung auf diese Spule durch die im Dielektrikum erzeugten dielektrischen "Wirbelströme" gemessen wird.
Diese dielektrischen Wirbelströme verändern zum Beispiel die Stromaufnahme und/oder die Phasenlage des die Feldspule durchfließenden Wechselstromes. Ist die Spule mit einem Kondensator zu einem Schwingkreis zusammengeschaltet, kann die Änderung der Resonanzfrequenz ausgewertet werden. Die im Dielektrikum erzeugten "Wirbelströme" erzeugen dabei eine Vergrößerung der Kapazität des Schwingkreises.

Die zur Messung notwendige Wechselspannung wird als Induktionsspannung des magnetischen Feldes der Wechselstrom-durchflossenen Spule aktiv erzeugt. Die im Dielektrikum entstehenden dielektrischen "Wirbelströme" können daher als Belastung der Spule proportional zur Dielektrizitätskonstanten des Dielektrikums gemessen werden.

Bei dieser Meßanordnung können auch ortsfeste oder große Prüflinge problemlos untersucht werden, da die Feldspule daneben angeordnet werden kann. Beispielsweise ist damit auch eine zerstörungsfreie Messung an Bauwerken möglich. Durch die hier vorgesehene induktive Dielektrizitätsmessung erhält man auch eine ausreichend große Eindringtiefe, so daß entsprechend aussagekräftige Meßergebnisse erzielbar sind. Beispielsweise bei der Feuchtemessung erfolgt eine direkte Messung des Flüssigkeitsgehaltes über die Dielektrizitätskonstante.
Durch das große L/C-Verhältnis mit kleiner Schwingkreiskapazität wirkt sich die kapazitive Last durch die im Dielektrikum des Prüflings entstehende dielektrischen Ströme besonders stark aus. Die Kapazität des Schwingkreises kann gegebenenfalls nur aus der Eigenkapazität der Spule und der Kapazität der Zuleitungen und der Ankoppelungsglieder bestehen.

Für eine gute Meßempfindlichkeit ist es ebenfalls zweckmäßig, wenn der Schwingkreis über eine schwache Ankopplung mit einem Oszillator verbunden ist, wobei der Oszillator vorzugsweise auf die Resonanzfrequenz des Schwingkreises abstimmbar ist. Durch die schwache Ankopplung wird der Schwingkreis nur sehr wenig gedämpft.

Eine abgewandelte Ausführungsform der Erfindung sieht vor, daß die Feldspule und ein parallel geschalteter Schwingkreis-Kondensator Bestandteil eines vorzugsweise frequenz- und/oder amplituden-variablen Oszillators sind und daß an den Schwingkreis eine Meßeinrichtung zur Messung einer Kapazitätsveränderung sowie gegebenenfalls eine weitere Meßeinrichtung zur Messung einer Amplitudenveränderung angeschlossen sind.
Dadurch ist getrennt und/oder gleichzeitig eine Messung der Dielektrizitätskonstante und andererseits eine Messung der dielektrischen Verluste zum Beispiel durch den Isolationswiderstand, durch ohmsche oder elektronische Leitfähigkeit und dergleichen möglich.

Bei der Messung und Untersuchung von Prüflingen mit großer Schichtdicke und/oder großer Dielektrizitätskonstante ist nach einer Weiterbildung der Erfindung vorgesehen, daß an dem Prüfling ein vorzugsweise streifenförmiger, insbesondere dünner Fortsatz vorgesehen ist, der in dem magnetischen Wechselfeld angeordnet ist. In einem solchen dünnen Fortsatz verlaufen die induzierten Ströme in geometrisch besser definierten Bahnen. Es wird dabei vermieden, daß sich "wilde Wirbelströme" mit undefinierter Geometrie ausbilden können. Auch werden dadurch Anpassungsschwierigkeiten durch ein relatives hochohmiges magnetisches Wechselfeld, andererseits durch einen Prüfling hoher Masse mit gegebenenfalls hoher Dielektrizitätskonstante vermieden.

Zusätzliche Ausgestaltungen den Erfindung sind in den weiteren Unteransprüchen aufgeführt. Nachstehend ist die Erfindung mit ihren wesentlichen Einzelheiten anhand der Zeichnungen noch näher erläutert.

Es zeigt:
- Fig. 1: einen prinzipiellen Meßaufbau einer Meßvorrichtung in Seitenansicht und
- Fig. 2: in Aufsicht,
- Fig. 3: eine Meßanordnung mit einem Schwingkreis,
- Fig. 4: eine Meßanordnung zur getrennten Messung der Dielektrizitätskonstante und der dielektrischen Verluste,
- Fig. 5: eine in einem Bohrloch eines Prüflings befindliche Feldspule,
- Fig. 6: eine hufeisenförmige Feldspulenanordnung,
- Fig. 7: eine Toroid-Spulenanordnung,
- Fig. 8: eine Feldspule mit einer Topfkernhalbschale,
- Fig. 9: eine Meßanordnung mit einem zwischen einer Feldspule und einer Empfängerspule angeordneten Prüfling,
- Fig. 10 und 11: verschiedene Meßbrücken-Anordnungen,
- Fig. 12: eine Meßanordnung zur Messung von Prüflingen mit hoher Schichtdicke und/oder großer Dielektrizitätskonstante,
- Fig. 13: ein praktisches Anwendungsbeispiel mit Anordnung einer Meßvorrichtung zur Feuchtemessung von Blumenerde,
- Fig. 14: eine Aufsicht einer als Flachspule ausgebildeten Feldspule,
- Fig. 15: eine Schmalseitenansicht der in Fig. 14 gezeigten Feldspule und
- Fig. 16: eine Meßvorrichtung zur Druckmessung.

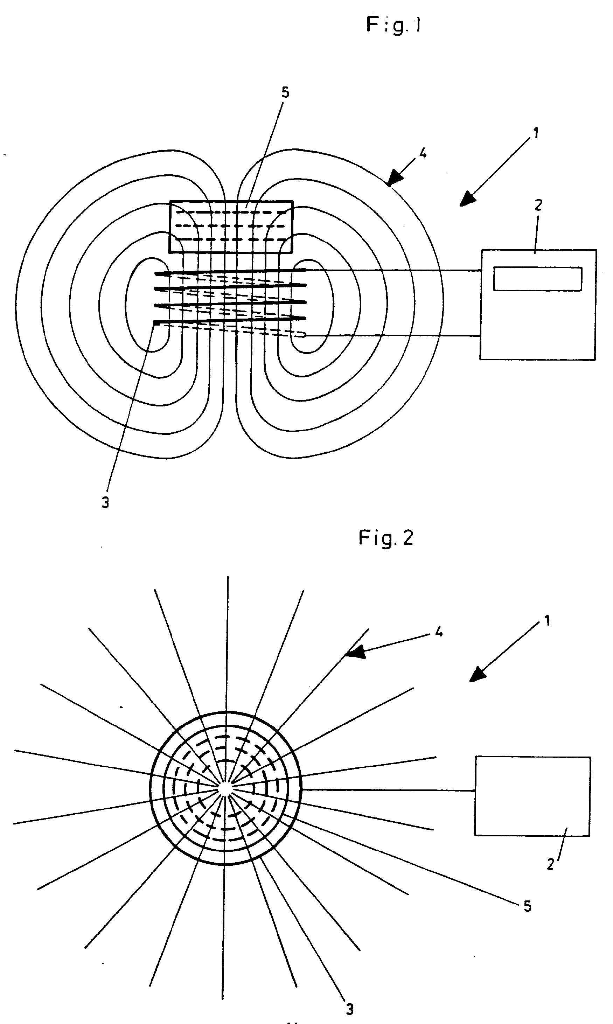

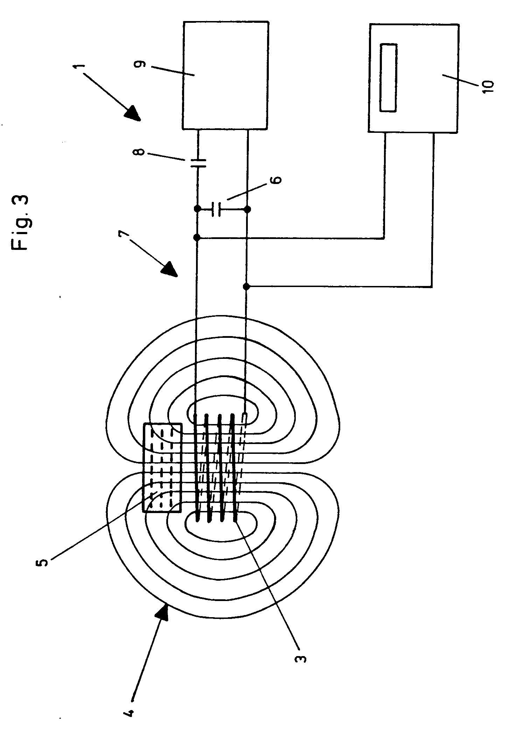

Eine prinzipiell in Fig. 1 und 2 gezeigte Meßvorrichtung 1 zeigt ein Induktivitätsmeßgerät 2, welches einen Oszillator beinhaltet, der eine äußere Feldspule 3 erregt. Diese Feldspule 3 erzeugt ein magnetisches Wechselfeld 4, welches einen Prüfling 5 durchflutet. Die dielektrischen Eigenschaften des Prüflings 5 verursachen eine Veränderung des magnetischen Wechselfeldes 4 und die dadurch verursachte Rückwirkung auf dieses Wechselfeld wird von dem Meßgerät 2 gemessen.
Wie in den Figuren 1 und 2 erkennbar, ist dabei die Feldspule 3 neben dem Prüfling 5 angeordnet. Die Meßvorrichtung eignet sich dadurch auch für Messungen an ortsfesten Prüflingen, beispielsweise zur Feuchtigkeitsmessung an Mauern.

Eine bevorzugte Ausführungsform der Meßvorrichtung 1 zeigt Fig. 3. Hierbei ist die Feldspule 3 Bestandteil eines Schwingkreises mit einem zu der Feldspule 3 parallel geschalteten Kondensator 6. Dieser Schwingkreis 7 ist über einen Koppelkondensator 8, der nur eine geringe Kapazität von z. B. einigen Picofarad aufweist, an einen abstimmbaren Oszillator 9 angeschlossen. Der Schwingkreis kann in seiner Resonanzfrequenz erregt werden.

Der Schwingkreis 7 ist mit hoher Güte und mit einem großen L/C-Verhältnis ausgelegt, wobei der Kondensator 6 eine sehr geringe Kapazität und die Feldspule 3 eine große Induktivität haben. Dadurch wirkt sich die kapazitive Last durch die im Prüfling entstehenden dielektrischen Ströme besonders stark aus und es ergibt sich dementsprechend eine hohe Meßemplichkeit. Die kapazitive Last führt nämlich zu einem Verstimmen des Schwingkreises 7, wobei die Verstimmung ein Maß für den dielektrischen Strom und somit ein Maß für die Dielektrizitätskonstante ist. Gegebenenfalls genügt bereits die Eigenkapazität der Spule und die Kapazität der Zuleitungen und der Ankopplungsglieder zur Bildung der Schwingkreiskapazität.
Die Wechselspannung am Schwingkreis 7 kann mit einem HF-Voltmeter oder einem Oszillographen 10 gemessen und beobachtet werden.
Bringt man in das magnetische Wechselfeld der Feldspule 3 einen Prüfling 5, z. B. ein Dielektrikum, erfolgt eine Änderung der Amplitude infolge der Verstimmung des Schwingkreises. Diese Änderung kann empirisch kalibriert und z. B. zur Bestimmung oder zur Anzeige der Dielektrizitätskonstante des Prüflings benutzt werden. Bei Einstellung der Frequenz auf eine Flanke der Resonanzkurve erhält man eine besonders gute Empfindlichkeit. Durch Dämpfung des Schwingkreises kann die Breite der Resonanzkurve und damit der Meßbereich und die Empfindlichkeit eingestellt werden. Wenn anstatt des Oszillographen 10 (Fig. 3) ein Frequenzmesser eingesetzt wird, so kann jeweils vor und nach dem Einbringen eines Prüflings in das magnetische Wechselfeld 4 der Feldspule 3 die Resonanzfrequenz (Amplitudenmaximum) abgelesen und entsprechend ausgewertet werden.

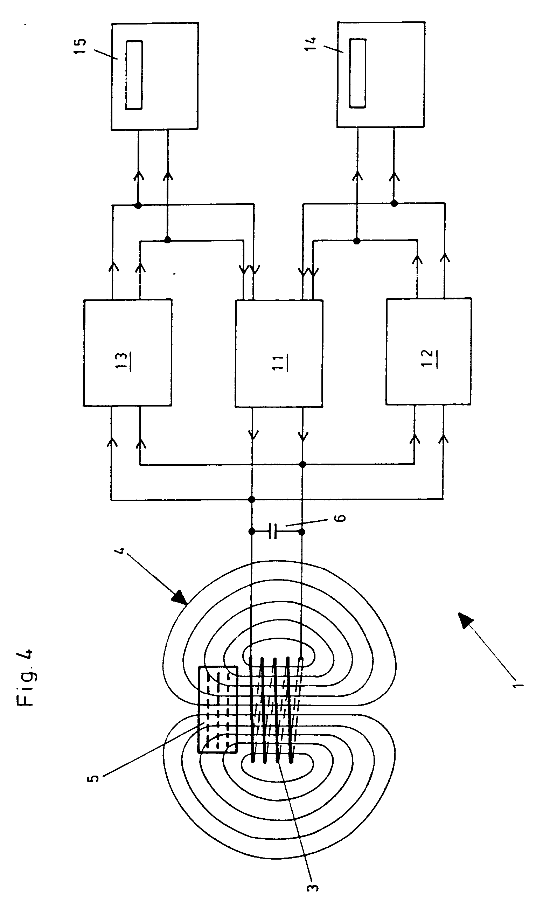

Fig. 4 zeigt eine Meßvorrichtung 1, bei der getrennt einerseits die Rückwirkung der dielektrischen Ströme und andererseits der Ströme, die die Verluste verursachen, erfaßt bzw. gemessen und bewertet werden können. Dazu sind die Feldspule 3 und der parallel dazu geschaltete Kondensator 6 Bestandteil eines frequenz- und amplitudenvariablen Oszillators 11. An den Schwingkreis 7 ist eine Meßeinrichtung 12 zur Messung einer Kapazitätsveränderung und eine weitere Meßeinrichtung 13 zur Messung einer Amplitudenveränderung. Die Änderung der Amplitude ist dann ein Maß für die Verluste und die Frequenzänderung ist ein Maß für die Dielektrizitätskonstante des Prüflings 5.
Im Ausführungsbeispiel sind an die Ausgänge der Meßeinrichtungen 12 und 13 jeweils Anzeigegeräte, insbesondere Spannungsmesser 14, 15 zur Anzeige der jeweiligen Meßwerte angeschlossen.
Die vorzugsweise als Regler ausgebildeten Meßeinrichtungen 12 und 13 sind mit ihren Ausgängen auch an den Oszillator 11 angeschlossen und auf diesen zurückgeführt und es erfolgt durch die Regelspannungen ein Rückführen und Regeln des Oszillators auf festeingestelle Sollwerte.
Bei der praktischen Handhabung wird vor einer Messung eine Kalibrierung mit Proben mit bekannter Dielektrizitätskonstante und auch mit bekannten Verlusten vorgenommen. Wenn anschließend ein Prüfling 5 mit gleichen Abmessungen in gleicher Weise in das magnetische Wechselfeld 4 eingebracht wird, können die Dielektrizitätskonstante und die Verluste gemessen und angezeigt werden.
Erwähnt sein noch, daß auch eine Einstellung z. B. auf Mitte einer Flanke der Resonanzkurve erfolgen kann, wodurch eine einfache Richtungserkennung der Regelspannung ermöglicht wird. Anstelle der Frequenzmodulation kann auch mit gleicher oder ähnlicher Meßanordnung eine Phasendemodulation vorgesehen sein, wobei die Phasenänderung dann dem Meßsignal entspricht.

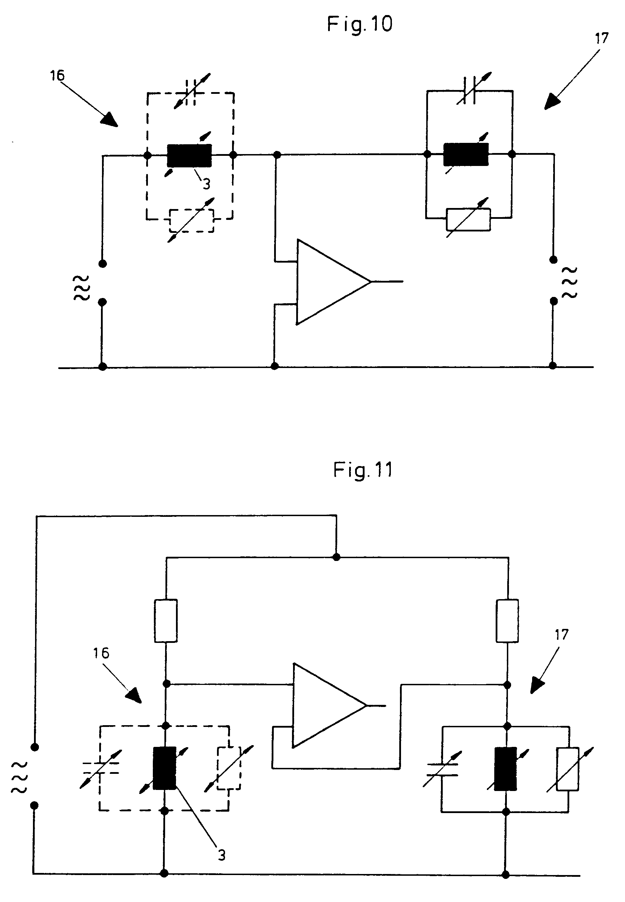

In Fig. 10 und 11 sind noch Meßvorrichtungen 1 gezeigt, die durch Meßbrücken realisiert sind. Gemäß Fig. 10 sind zwei Resonanzkreise 16, 17 in einen Brückenzweig eingesetzt. Der Resonanzkreis 17 dient hierbei zur Bildung einer Referenzgröße, wobei die zu diesem Resonanzkreis 17 gehörenden parallel geschalteten Bauteile - Kondensatorspule, Widerstand - einstellbar sind, so daß auf BrückenNull abgeglichen werden kann.
Zu dem anderen Resonanzkreis 16 gehört die Feldspule 3 sowie der dazu parallel geschaltete und strichliniert angedeutete Kondensator, der die Meßgröße wiedergibt. Außerdem ist zur Feldspule 3 ebenfalls strichliniert angedeutet ein Widerstand geschaltet, der die Leitfähigkeit des gemessenen Dielektrikums bzw. den Verlustwiderstand wiedergibt.

Fig. 11 zeigt eine etwas gegenüber Fig. 10 abgewandelte Meßbrückenanordnung, wobei die Resonanzkreise 16 und 17 jeweils in einem Brückenzweig angeordnet sind.
Die in Fig. 10 und 11 gezeigten Meßvorrichtungen 16 mit Meßbrückenanordnungen eignen sich insbesondere für Messungen von Prüflingen 5 mit hoher Leitfähigkeit.

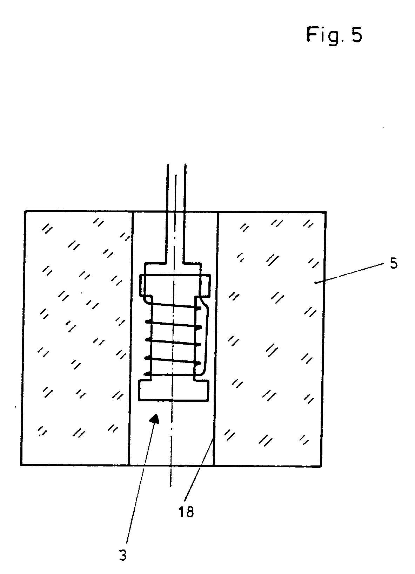

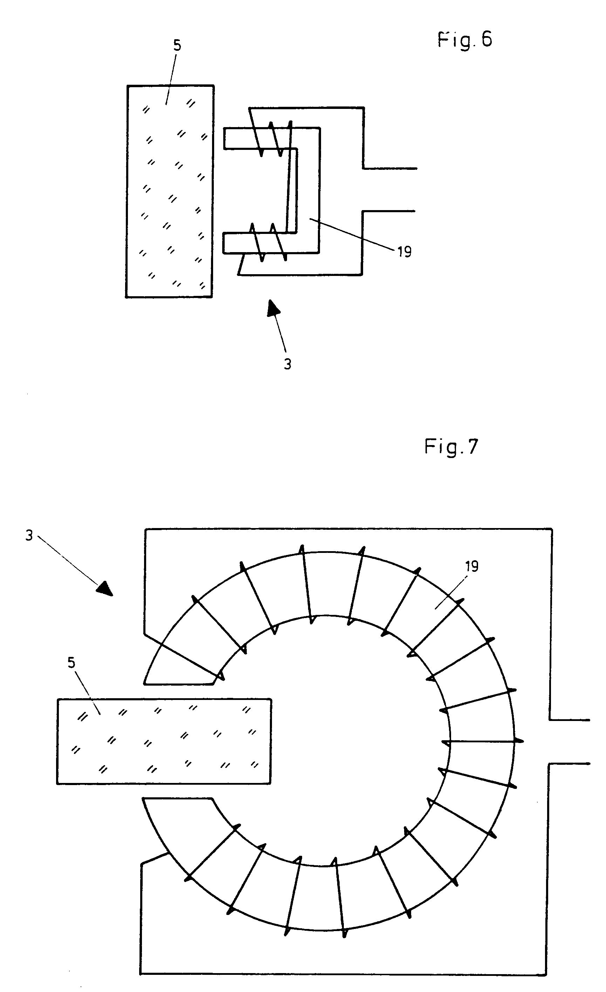

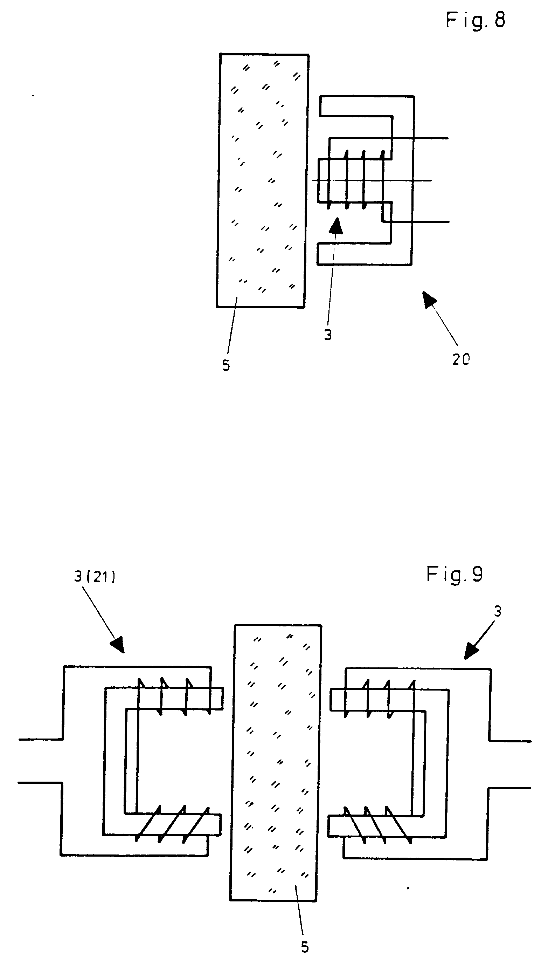

Die Figuren 5 bis 8 zeigen unterschiedlich ausgebildete Feldspulen 3. Die Feldspule 3 kann dabei sowohl neben dem Prüfling 5 (vgl. Fig. 6 und 8) oder aber in dem Prüfling (Fig. 5) angeordnet sein. Bei der Ausführungsform der Feldspule 3 gemäß Fig. 7 ist der Prüfling 5 in einen Schlitz einer Ringspule eingesetzt. Gemäß Fig. 5 taucht die Feldspule 3 in ein Bohrloch 18 eines Prüflings 5. Fig. 6 zeigt eine hufeisenförmige Feldspulenanordnung, bei der ein ferromagnetischer Kern 19 an seinen beiden Schenkeln mit Teilwicklungen der Feldspule 3 versehen sind. Fig. 8 zeigt eine Feldspule, bei der als ferromagnetischer Kern eine Topfkern-Halbschale 20 vorgesehen ist.

Die Meßanordnung gemäß Fig. 9 zeigt zwei zueinander weisende Feldspulen 3, zwischen denen der Prüfling 5 angeordnet ist. Die beiden Feldspulen können in Serie geschaltet sein und damit eine gemeinsame Induktivität darstellen. Diese Anordnung ist besonders für die Messung von plattenförmigen Prüflingen 5 geeignet.
Andererseits besteht aber auch die Möglichkeit, daß die eine Feldspule 3 (z. B. rechts) z. B. gemäß Fig. 1 an ein Induktivitätsmeßgerät 2 angeschlossen ist, während die auf der anderen Seite des Prüflings 5 befindliche Spule als Empfängerspule 21 dient, die an einen Meßempfänger angeschlossen ist. Die im Empfänger gemessene Empfangsspannung wird hierbei durch den Prüfling 5 mehr oder weniger abgeschirmt. Eine Veränderung der Dielektrizitätskonstante und/oder der Verluste des Prüflinges können somit auch in dem Empfänger gemessen oder beobachtet werden. Zur Vergrößerung der Empfindlichkeit können die Spannungen des Empfängers mit einem Teil der Spannung des auf der anderen Seite an die Feldspule 3 angeschlossenen Oszillators kompensiert werden. Die Empfindlichkeit kann so um ein Vielfaches gesteigert werden. Diese Anordnung ist insbesondere für Prüflinge mit größeren Abmessungen und/oder mit großer Dielektrizitätskonstante, z. B. zur Messung feuchter Erde, geeignet.

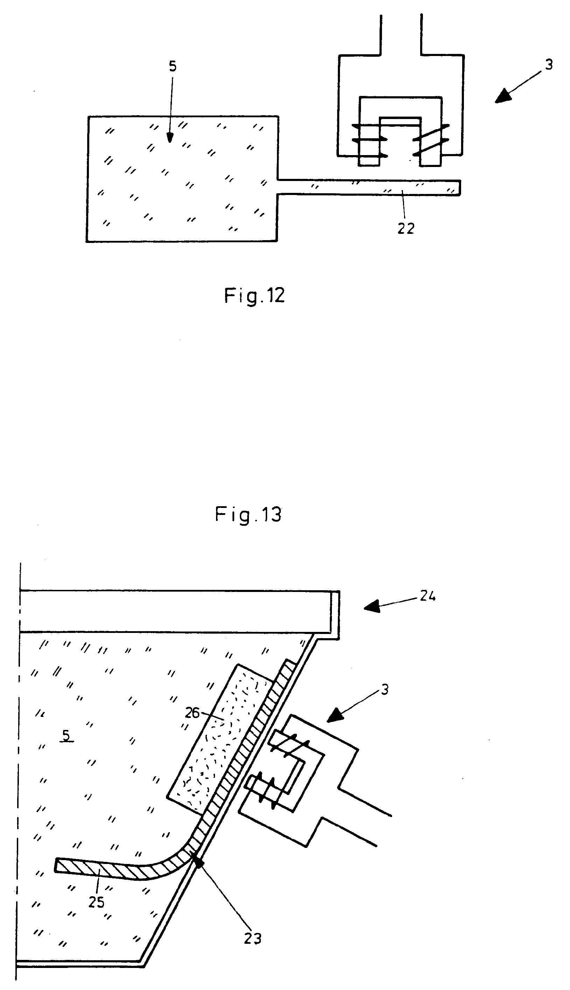

Eine abgewandelte Meßanordnung zur Messung von Prüflingen 5 mit größerer Schichtdicke oder größeren Abmessungen zeigen die Figuren 12 und 13.
Bei größeren Schichtdicken oder größeren Abmessungen des Prüflings 5 und auch bei größerer Dielektrizitätskonstante, wie dies z. B. bei feuchter Erde, Torf, Sand usw. der Fall ist, muß bei der Auslegung der Meßanordnung auf die Anpassung des magnetischen Wechselfeldes einerseits und den Innenwiderstand des Prüflings, der durch die Dielektrizitätskonstante und die Verluste gebildet wird, geachtet werden. Bei solchen Prüflingen kann dann, wie in Fig. 12 gezeigt, die Messung an einem streifenförmigen Fortsatz 22 des Prüflings 5 vorgenommen werden. In dem sich bei der Feldspule 3 ausbildenden magnetischen Wechselfeld liegt dann nur noch ein Teil des Fortsatzes 22, so daß die vorerwähnten Probleme bei Prüflingen hoher Schichtdicke bzv. großer Dielektrizitätskonstante nicht mehr auftreten.
Anstatt eines einstückigen Fortsatzes 22 eines Prüflinges 5, wie in Fig. 12 gezeigt, kann auch ein Zwischenübertragungsteil 23, wie in Fig. 13 gezeigt, vorgesehen sein. Dieses Zwischenübertragungsteil 23 kann aus einem Streifen aus Papier, Textil oder Schaumstoff bestehen. Außerdem eignet sich hierzu auch eine dünne gepreßte oder geleimte Torfschicht, die auf Papier oder Textil oder eine ähnliche Unterlage aufgebracht ist.
Bei dem in Fig. 13 gezeigten Prüfling 5 handelt es sich um in einem Blumentopf 24 befindliche Erde oder Torf.
Bei geringerem Feuchtegehalt dieses Prüflings kann eine Feldspule 3 einer erfindungsgemäßen Meßvorrichtung direkt außen am Blumentopf 24 zur Messung der Feuchte positioniert werden. Durch dieses Positionieren der Feldspule außerhalb und neben dem Blumentopf 24 besteht nun die Möglichkeit, auch größere Pflanzanlagen mit einer großen Anzahl von in Reihen aufgestellten Blumentöpfen, wie dies in Gärtnereien üblich ist, auf den Feuchtegehalt der darin befindlichen Erde zu überwachen. Die Meßvorrichtung mit der Feldspule 3 kann dabei an den Blumentöpfen vorbeibewegt und dann kann nach gemessenem Feuchtegehalt Gießwasser in einer bestimmten Menge zugeführt werden. Durch diese berührungslose Messung lassen sich auch Großanlagen in vergleichsweise kurzer Zeit genau dosiert mit Wasser versorgen.

Bei höherem Feuchtegehalt der Erde kann die in Fig. 13 gezeigte Ausbildung vorteilhaft sein. In diesem Falle ist ein als Folienstreifen 25 ausgebildetes Zwischenübertragungsteil 23 bereichsweise an dem Blumentopf 24 innenseitig anliegend und bereichsweise in die Erde (Prüfling 5) ragend angeordnet. Der Folienstreifen 25 besteht aus einem Material, welches Feuchtigkeit leicht aufnehmen und auch wieder abgeben kann. An der Innenseite des Folienstreifens 25, im Bereich wo dieser am Blumentopf innenseitig anliegt, ist gegenüberliegend zu der äußeren Feldspule 3 eine Abschirmung 26 aus magnetisch und elektrisch isolierendem Material vorgesehen. Dadurch wird bewirkt, daß innerhalb des magnetischen Wechselfeldes 4 im wesentlichen nur der dort befindliche Teil des Folienstreifens für die Messung wirksam ist.
Die Abschirmung 26 besteht vorzugsweise aus einem Styroporplättchen. Das durch einen Folienstreifen 25 gebildete Zwischenübertragungsteil 23 kann aus einem Streifen Papier, Textil, Schaumstoff oder dgl. oder gegebenenfalls aus einer dünnen gepreßten oder geleimten oder auf Papier oder Textil aufgebrachten Torfschicht bestehen.

Erwähnt sei noch, daß die Feldspule 3 je nach Einsatz der Meßvorrichtung 1 mit oder ohne ferromagnetischen Kern ausgebildet sein kann.

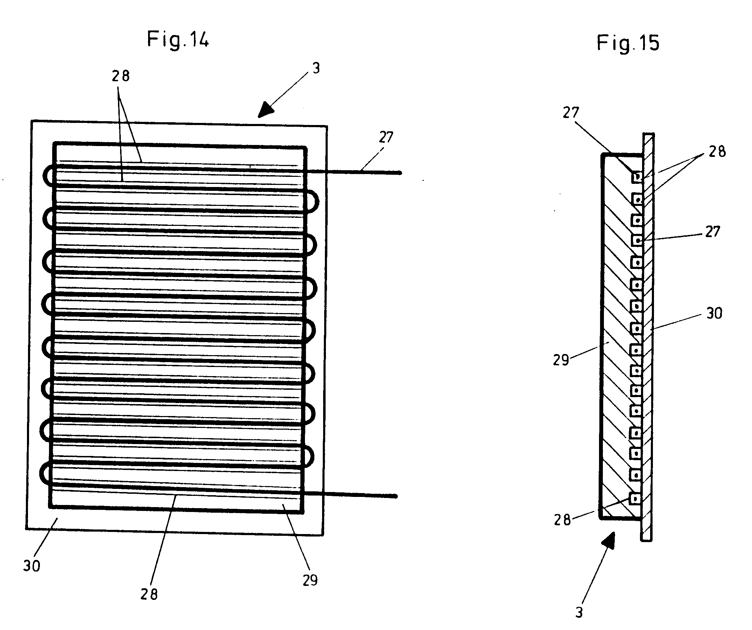

Fig. 14 und 15 zeigen eine Feldspule 3, die hier als Flachspule ausgebildet ist. Dabei ist der Spulendraht 27 in parallele Nuten 28 einer Platte 29 aus ferromagnetischem Material eingelegt. Fig. 14 läßt erkennen, daß der Spulendraht mäanderförmig in die Nuten 28 eingelegt ist.

Die Platte 29 bildet hier den Spulenkern. Die mit den Nuten 28 versehene Seite der Platte 29 ist durch eine Folie 30 abgedeckt. Durch eine solche Feldspulen-Ausbildung erhält man eine Vielzahl langer Pole, durch die die Einflüsse der Rückwirkungen des Dielektrikums wesentlich verstärkt werden.
Die Anordnung gemäß Fig. 14 und 15 eignet sich zur Messung von Kräften, Feuchte und auch zur Gasanalyse, wobei diese Größen auf die Folie 30 einwirken und deren Dielektrizitätskontante dabei verändern. Bei einer Kraftmessung können die Kräfte sowohl quer zur Folienebene als auch in der Folienlängsebene eingeleitet werden.

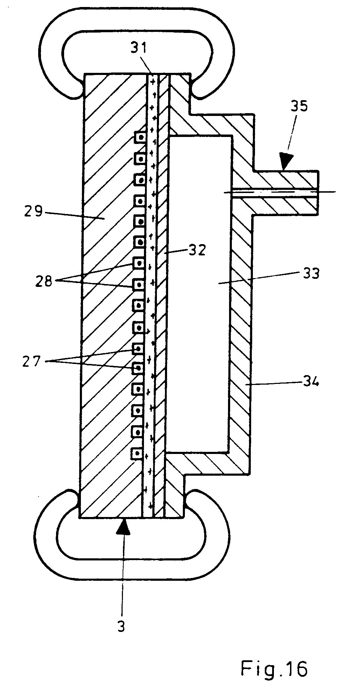

Eine praktische Anwendung der in Fig. 14 und 15 gezeigten Anordnung zeigt Fig. 16. Die Feldspule ist hierbei durch eine Gewebeschicht 31 abgedeckt, auf der sich eine Folie 32 befindet. Diese Folie 32 bildet eine Seitenbegrenzung eines Druckraumes 33, der im übrigen durch eine Druckglocke 34 begrenzt ist. Der über einen Anschluß 35 zugeführte Druck kann durch Änderung der Dielektrizitätskonstante des Gewebes 31 gemessen werden. Anstatt einer Geweneschicht 31 könnt auch dort eine Folie vorgesehen sein. Anstatt der Folie 32 kann auch eine Metallmembrane angeordnet sein, durch die eine magnetische Feldbündelung mit Verdichtung des magnetischen Feldes in der der Spule zugewandten Folie oder Schicht erfolgt.

Erwähnt sei noch, daß die erfindungsgemäße Meßvorrichtung 1 nicht nur zur direkten Anzeige der Dielektrizitätskonstante sondern indirekt auch für andere physikalische Größen benutzt werden kann. Beispielsweise besteht die Möglichkeit, Feuchte in Holz, Bodenproben und Baumaterialien zu messen oder aber paramagnetische und diamagnetische Eigenschaften von Feststoffen und Flüssigkeiten (z. B. Wassergehalt von Alkohol) oder beispielsweise den O₂-Gehalt von Gasen. Die erfindungsgemäße Meßvorrichtung 1 weist eine hohe Meßempfindlichkeit auf und eignet sich deshalb auch zur Messung der Feuchtigkeit dünnster Schichtdicken wie z. B. von Papier, Textilien, Kunststoffolien oder auch von einem Gel. Auch ist die Meßvorrichtung zur Feuchtemessung von Luft oder Gasen sowie zur Messung von Drücken und Kräften geeignet.
Bei Bodenproben und Bodenuntersuchungen ebenso wie bei Baustoffen, Holz usw. können über die gemessenen Verluste Aussagen über den Zustand und die Konzentration des Elektrolygehaltes gemacht werden oder es sind Meßgrößen erhältlich, welche in einem bestimmten Verhältnis zu den Eigenschaften und der Konzentration oder der Zustände des Prüflings stehen.
Da die Messung der Induktivität und auch der Verluste augenblicklich erfolgt, kann die Meßvorrichtung auch gut für kontinuierliche Messungen, d. h. z. B. bei fließenden Gasen oder Flüssigkeiten oder bei laufenden Bändern oder bei fließenden oder laufenden Schüttgut angeordnet werden.

## Patentansprüche

1. Meßvorrichtung zur Bestimmung der dielektrischen Eigenschaften eines Prüflings aus Stoffen in beliebigen Aggregatzustand, zum Beispiel von Nichtleitern, Halbleitern, Isolierstoffen, Baustoffen, Baumaterialien, Bodenproben, Schüttgütern, Lösungen, Lösungsmitteln, Gasen usw. mit einer Spule, die Bestandteil eines Schwingkreises ist zur Erzeugung eines magnetischen Wechselfeldes, in welches der Prüfling eintaucht, **dadurch gekennzeichnet,** daß die Feldspule (3) einen magnetisierbaren Kern aufweist und daß der Schwingkreis (7) zur Messung der Dielektrizitätskonstanten des Prüflings ein großes L/C-Verhältnis mit kleiner Schwingkreiskapazität von etwa 0,1 Picofarad bis zu etwa 50 Picofarad aufweist.

2. Meßvorrichtung nach Anspruch 1, dadurch gekennzeich net, daß der Schwingkreis (7) über eine schwache Ankopplung mit einem Oszillator (9) verbunden ist und daß der Oszillator vorzugsweise auf die Resonanzfrequenz des Schwingkreises abstimmbar ist.

3. Meßvorrichtung nach Anspruch 1 oder 2, dadurch gekennzeichnet, daß zusätzlich zu der Feldspule (3) zur Erzeugung des magnetischen Wechselfeldes eine mit einem Empfänger verbundene Spule (21) vorgesehen ist und daß sich das Meßfeld für den Prüfling (5) zwischen diesen beiden Spulen (3, 21) befindet.

4. Meßvorrichtung nach einem der Ansprüche 1 bis 3, dadurch gekennzeichnet, daß als Meßgerät zur Messung der durch den Prüfling verursachten Rückwirkung auf das Wechselfeld ein HF-Voltmeter und/oder ein Oszillograph (1o) vorgesehen ist.

5. Meßvorrichtung nach einem der Ansprüche 1 bis 4, dadurch gekennzeichnet, daß die Feldspule (3) und ein parallel geschalteter Schwingkreis-Kondensator (6) Bestandteil eines frequenz- und/oder amplituden-variablen Oszillators sind und daß an den Schwingkreis (7) eine Meßeinrichtung (12) zur Messung einer Kapazitätsveränderung sowie gegebenenfalls eine weitere Meßeinrichtung (13) zur Messung einer Amplitudenveränderung angeschlossen sind.

6. Meßvorrichtung nach Anspruch 5, dadurch gekennzeichnet, daß an den Oszillator-Schwingkreis ein Regler zur Frequenznachregelung sowie gegebenenfalls ein Regler zur Amplitudennachregelung des Oszillators vorgesehen sind und daß an die Reglerausgänge Meßgeräte (14, 15) zur Messung der Regelspannungen angeschlossen sind.

7. Meßvorrichtung, insbesondere nach Oberbegriff des Anspruches 1, dadurch gekennzeichnet, daß die Feldspule (3) Bestandteil einer Meßbrücken-Anordnung ist.

8. Meßvorrichtung zur Untersuchung von Prüflingen mit großer Schichtdicke und/oder großer Dielektrizitätskonstante,nach einem der Ansprüche 1 bis 7, dadurch gekennzeichnet, daß ein mit dem Prüfling (5) verbindbarer, vorzugsweise streifenförmiger, insbesondere dünner Fortsatz (22) vorgesehen ist, der in dem magnetischen Wechselfeld (4) angeordnet ist.

9. Meßvorrichtung nach einem der Ansprüche 1 bis 8, dadurch gekennzeichnet, daß zur Feuchtemessung ein Feuchtigkeit aufnehmendes Zwischenübertragungsteil (23) bei dem magnetischen Wechselfeld (4) vorgesehen ist.

10. Meßvorrichtung zur Feuchtemessung von in einem Blumentopf oder dgl. Behältnis befindlicher Erde, insbesondere nach Anspruch 9, dadurch gekennzeichnet, daß ein vorzugsweise streifenförmiges Zwischenübertragungsteil (Streifen) (23) innenseitig an der Topfwand zumindest bereichsweise anliegend angeordnet ist, daß sich außerhalb des Topfes im Bereich dieses Streifens die Feldspule (3) befindet und daß auf der Innenseite des Streifens vorzugsweise eine Abschirmung aus magnetisch und elektrisch isolierendem Material im Bereich des Wechselfeldes (4) vorgesehen ist.

11. Meßvorrichtung nach Anspruch 9 oder 10, dadurch gekennzeichneet, daß das Zwischenübertragungsteil (23) aus einem Streifen aus dünnem Papier, Textil, Schaumstoff oder dergleichen oder gegebenenfalls einer dünnen gepreßten oder geleimten oder auf Papier oder Textil oder dergleichen aufgebrachten Torfschicht besteht.

12. Meßvorrichtung nach einem oder mehreren der Ansprüche 1 bis 11, dadurch gekennzeichnet, daß die Feldspule (3) als Zylinderspule gegebenenfalls mit ferromagnetischem Kern ausgbildet ist.

13. Meßvorrichtung nach einem der Ansprüche 1 bis 11, dadurch gekennzeichnet, daß die Feldspule (3) einen hufeisenförmigen Kern mit zwei darauf aufgebrachten Teilwicklungen aufweist.

14. Meßvorrichtung nach einem der Ansprüche 2 bis 11, dadurch gekennzeichnet, daß die Feldspule (3) einen durch eine Topfkern-Halbschale (2o) gebildeten ferromagnetischen Kern aufweist.

15. Meßvorrichtung nach einem der Ansprüche 1 bis 14, dadurch gekennzeichnet, daß ein kraftbeaufschlagbares Gewebe (31), Folie (3o) oder dergleichen innerhalb des magnetischen Wechselfeldes (4) zur Messung der bei Kraftbeaufschlagung sich ändernden Dielektrizitätskonstante angeordnet ist.

16. Meßvorrichtung nach einem der Ansprüche 1 bis 15, dadurch gekennzeichnet, daß die Feldspule (3) als Flachspule mit einer vorzugsweise mäanderförmigen Wicklung ausgebildet ist, die vorzugsweise in Nuten (28) eines flachen Körpers (29) aus ferromagnetischen Material eingelegt ist.

17. Meßvorrichtung nach Anspruch 16, dadurch gekennzeichnet, daß die Flachspule (3) im wesentlichen unmittelbar oder wenigstens mit einer Feuchtigkeit aufnehmenden und/oder kraftbeaufschlagbaren Folie, insbesondere aus Papier, Textil, Schaumstoff oder dergleichen belegt ist.

18. Meßvorrichtung nach einem der vorstehenden Ansprüche, dadurch gekennzeichnet, daß die Flachspule (3) mit einem Gewebe belegt und einer darauf befindlichen Folie abgedichtet ist, die eine Seitenbegrenzung eines Druckraumes (33) bildet.

## Claims

1. A measurement device for the analysis of the dielectric characteristics of a sample from materials in any state of aggregation, for example, non-conducting materials, semi-conducting (semi-conductors), insulating materials, building materials, soil samples, bulk products, solutions, solvents, gases, etc. by means of a coil forming an integral part of a resonant circuit intended to create an alternating magnetic field in which the sample is inserted, **wherein** the inductive coil (3) has a magnetizable core and the resonant circuit (7) has a significant LC ratio, with a low resonance capacity of approximately 0.1 picofarad to approximately 50 picofarads.

2. A measurement device, as claimed in Claim 1, wherein the resonant circuit (7) is linked (3) to an oscillator (9) through a low coupling connection and wherein the oscillator can preferably be adjusted to the resonant frequency of the resonant circuit.

3. A measurement device, as claimed in Claim 1 or 2, wherein, beside the inductive coil (3) intended to create the magnetic field, a coil (21) is connected to an alternating receiver, so that the sample measurement field (5) is located between said coils (3, 21).

4. A measurement device, as claimed in any of Claims 1 to 3, wherein a HF voltmeter and/or a scope (10) is provided as a meter for the measurement of the feedback reaction generated by the sample on the alternating field.

5. A measurement device, as claimed in any of Claims 1 to 4, wherein the inductive coil (3) and a resonance capacitor (6), connected in parallel, are part of a frequency and/or amplitude variable oscillator and wherein a measurement device (12) detecting a change of capacity and, as required, another measurement device (13) detecting an amplitude variation are connected to the resonant circuit (7).

6. A measurement device, as claimed in Claim 5, wherein a frequency adjustment regulator and, as required, an amplitude adjustment regulator for the adjustment of the oscillator are provided in the resonant circuit of the oscillator and wherein measurement devices (14, 15) are linked to the outputs of the regulator for the measurement of regulation voltages.

7. A measurement device, particularly as described by the general term disclosed in Claim 1, wherein the inductive coil (3) is part of a measuring circuit.

8. A device for the analysis of samples with a significant thickness and/or with a high dielectric constant, as claimed in any of Claims 1 to 7, wherein an extension is provided, preferably as a very thin strip (22) which can be attached to the sample (5), in the alternating magnetic field (4).

9. A measurement device, as claimed in any of Claims 1 to 8, wherein the dampness measurement is performed by means of an intermediate transfer part (23) provided near the alternating magnetic field (4).

10. A measurement device for the measurement of the dampness of soil in a flower pot or any other similar receptacle, particularly, as claimed in Claim 9, wherein an intermediate transfer part (strip) (23) is arranged along the internal wall of the flower pot so that said intermediate transfer part is partially in contact with the sample, and wherein the inductive coil (3) is arranged within the pot, in the area of said strip and wherein the internal part of the strip includes, preferably, a screen made of electric and magnetic insulating material, in the area of the alternating field (4).

11. A measurement device, as claimed in Claim 9 or 10, wherein the intermediate transfer part (23) comprises a thin strip in paper, textile, foam or other similar material, or, as required, a layer of peat pressed or bonded or attached on a paper or textile support.

12. A measurement device, as claimed in any of Claims 1 to 11, wherein the inductive coil (3) has a cylindrical shape and can also be produced with a ferromagnetic core.

13. A measurement device, as claimed in any of Claims 1 to 11, wherein the inductive coil (3) has a core with the shape of a horse shoe which legs comprise two partial windings.

14. A measurement device as claimed in any of Claims 1 to 11, wherein the inductive coil (3) has a half-shell pot core (20).

15. A measurement device, as claimed in any of Claims 1 to 14, wherein a fabric (31) subjected to a force, with a film (30) or a similar product is located in the alternating field (4) in order to measure the variation of the dielectric constant with respect to the force applied.

16. A measurement device, as claimed in any of Claims 1 to 15, wherein the inductive coil (3) has a flat shape, with a winding preferably meander-shaped and preferably located in the grooves (28) of a flat body (29) made of a ferromagnetic material.

17. A measurement device as claimed in Claim 16, wherein the major part of the flat inductive coil (3) is directly coated by a film absorbing dampness and/or subjected to a force, and composed of paper, textile, foam or other similar material.

18. A measurement device as claimed in any of the above-mentioned claims, wherein the flat inductive coil (3) is coated with a cloth covered by a tight film forming the side limit of a pressure chamber (33).

## Revendications

1. Dispositif de mesure pour la détermination des caractéristiques diélectriques d'un échantillon en matériaux se trouvant dans un état agrégatif quelconque, par exemple des non-conducteurs, semi-conducteurs, matériaux isolants, matières de construction, matériaux de construction, échantillons de sol, produits en vrac, solutions, solvants, gaz, etc. au moyen d'une bobine faisant partie d'un circuit résonant pour la création d'un champ magnétique alternatif dans lequel est plongé l'échantillon, **caractérisé en ce que** la bobine inductrice (3) présente un noyau magnétisable et que le circuit résonant (7) présente un rapport L/C important avec une faible capacité de résonance d'environ 0,1 picofarad à environ 50 picofarads.

2. Dispositif de mesure selon la revendication 1, caractérisé en ce que le circuit résonant (7) est raccordé à un oscillateur (9) par un faible couplage et que l'oscillateur est de préférence ajustable à la fréquence de résonance du circuit résonant.

3. Dispositif de mesure selon les revendications 1 ou 2, caractérisé en ce que, en plus de la bobine inductrice (3) prévue pour la création du champ magnétique, une bobine (21) est reliée à un récepteur alternatif, de sorte que le champ de mesure pour l'échantillon (5) se situe entre ces deux bobines (3, 21).

4. Dispositif de mesure selon l'une des revendications 1 à 3, caractérisé en ce qu'un voltmètre HF et/ou un oscilloscope (10) est prévu comme appareil de mesure pour la mesure de la rétroaction générée par l'échantillon sur le champ alternatif.

5. Dispositif de mesure selon l'une des revendications 1 à 4, caractérisé en ce que la bobine inductrice (3) et un condensateur de résonance (6), branché en parallèle, font partie d'un oscillateur variable en fréquence et/ou en amplitude et qu'un dispositif de mesure (12) détectant la variation de la capacité ainsi que, le cas échéant, un autre dispositif de mesure (13) détectant la variation de l'amplitude sont raccordés au circuit résonant (7).

6. Dispositif de mesure selon la revendication 5, caractérisé en ce qu'un régulateur d'ajustage de la fréquence ainsi que, le cas échéant, un régulateur d'ajustage de l'amplitude de l'oscillateur sont prévus sur le circuit résonant de l'oscillateur et que des appareils de mesure (14, 15) sont raccordés aux sorties du régulateur pour la mesure des tensions de régulation.

7. Dispositif de mesure, notamment selon le terme générique de la revendication 1, caractérisé en ce que la bobine inductrice (3) fait partie d'un circuit en pont de mesure.

8. Dispositif pour l'examen d'échantillons de grande épaisseur et/ou ayant une constante diélectrique élevée, selon l'une des revendications 1 à 7, caractérisé en ce qu'il est prévu de placer un prolongement, de préférence sous forme de bande particulièrement mince (22) pouvant être reliée à l'échantillon (5), dans le champ magnétique alternatif (4).

9. Dispositif de mesure selon l'une des revendications 1 à 8, caractérisé en ce que la mesure d'humidité s'effectue au moyen d'une pièce de transfert intermédiaire (23) prévue près du champ magnétique alternatif (4).

10. Dispositif de mesure d'humidité du terreau contenu dans un pot de fleurs ou dans un récipient similaire, en particulier selon la revendication 9, caractérisé en ce qu'une pièce intermédiaire de transfert (bande) (23) est disposée le long de la paroi intérieure du pot de fleurs et qu'elle touche partiellement l'échantillon, que la bobine inductrice (3) est disposée à l'extérieur du pot dans la zone de cette bande et que la partie intérieure de la bande comporte de préférence un écran en matériau isolant électrique et magnétique, dans la zone du champ alternatif (4).

11. Dispositif de mesure selon la revendication 9 ou 10, caractérisé en ce que la pièce de transfert intermédiaire (23) est composée d'une bande de faible épaisseur en papier, textile, mousse ou matériau similaire ou, le cas échéant, d'une couche de tourbe pressée ou encollée ou fixée sur un support papier ou textile.

12. Dispositif de mesure selon une ou plusieurs des revendications 1 à 11, caractérisé en ce que la bobine inductrice (3) en forme cylindrique peut être également réalisée avec un noyau ferromagnétique.

13. Dispositif de mesure selon une des revendications 1 à 11, caractérisé en ce que la bobine inductrice (3) présente un noyau en forme de fer à cheval dont les branches comportent deux enroulements partiels.

14. Dispositif de mesure selon l'une des revendications 1 à 11, caractérisé en ce que la bobine inductrice (3) présente un noyau en pot semi-coque (20).

15. Dispositif de mesure selon l'une des revendications 1 à 14, caractérisé en ce qu'un tissu (31) soumis à une force, avec film (30) ou un produit similaire est placé à l'intérieur du champ alternatif (4) pour mesurer la variation de la constante diélectrique en fonction de la force appliquée.

16. Dispositif de mesure selon l'une des revendications 1 à 15, caractérisé en ce que la bobine inductrice (3) est de forme plate avec un enroulement de préférence en forme de méandres, placé de préférence dans des rainures (28) d'un corps plat (29) en matériau ferromagnétique.

17. Dispositif de mesure selon la revendication 16, caractérisé en ce que la bobine inductrice plate (3) est recouverte sur sa majeure partie et directement d'un film absorbant l'humidité et/ou soumis à l'action d'une force, en papier, en textile, en mousse ou en un matériau similaire.

18. Dispositif de mesure selon l'une des revendications précédentes, caractérisé en ce que la bobine inductrice plate (3) est recouverte d'une toile sur laquelle est placé un film étanche, composant la limite latérale d'une chambre de pression (33).
